# FASCICULE DE BREVET EUROPEEN

(11) **EP 3 629 042 B1**
(45) Date de publication et mention de la délivrance du brevet: **10.05.2023**
(21) Numéro de dépôt: 19200128.7
(22) Date de dépôt: 27.09.2019
(51) Int. Cl.: G01R 31/52, H01H 47/00, H01H 71/46

(54) **PROCÉDÉ DE DIAGNOSTIC DE LA CAUSE DE DÉCLENCHEMENT D'UN APPAREIL DE PROTECTION ÉLECTRIQUE, APPAREIL AUXILIAIRE ET SYSTÈME ÉLECTRIQUE POUR LA MISE EN OEUVRE D'UN TEL PROCÉDÉ**
VERFAHREN ZUR DIAGNOSE DER URSACHE DER AUSLÖSUNG EINES ELEKTRISCHEN SCHUTZGERÄTS, HILFSGERÄT UND ELEKTRISCHES SYSTEM ZUR UMSETZUNG DIESES VERFAHRENS
METHOD FOR DIAGNOSING THE CAUSE OF TRIGGERING OF AN ELECTRICAL PROTECTION DEVICE, AUXILIARY DEVICE AND ELECTRICAL SYSTEM FOR IMPLEMENTING SUCH A METHOD

(30) Priorité: 28.09.2018 FR 1858967
(43) Date de publication de la demande: 01.04.2020
(73) Titulaire: Schneider Electric Industries SAS, 92500 Rueil Malmaison (FR)
(72) Inventeur: HENNEQUIN, Michel, 38050 Grenoble Cedex 03 (FR); YOUSSEF, Wedian, 38050 Grenoble Cedex 09 (FR)
(74) Mandataire: Lavoix

(56) Documents cités:
- FR-A1- 3 010 531
- FR-A1- 3 010 584

## Description

La présente invention concerne un procédé de diagnostic de la cause de déclenchement d'un appareil de protection électrique. L'invention concerne également un appareil auxiliaire et un système électrique pour la mise en oeuvre d'un tel procédé de diagnostic.

Les installations électriques comportent généralement un ou plusieurs appareils de protection électrique, tels que des disjoncteurs, pour interrompre la circulation du courant électrique dans un ou plusieurs conducteurs électriques de l'installation en cas de détection d'un défaut électrique, tel qu'un court-circuit ou une surcharge dans l'installation.

A cet effet, l'appareil de protection comprend un dispositif de déclenchement prévu pour détecter un ou plusieurs défauts électriques et, en réponse, commuter l'appareil de protection vers un état électriquement ouvert.

Lorsque l'appareil de protection est déclenché, il est souhaitable de pouvoir identifier le type de défaut électrique ayant conduit au déclenchement, car cela facilite la gestion et la supervision de l'installation électrique.

C'est pourquoi des appareils auxiliaires sont parfois ajoutés aux côtés de l'appareil de protection, afin d'assurer des fonctions de surveillance et de diagnostic, sans avoir besoin de remplacer complètement les appareils de protection déjà installés.

Les fonctions de surveillance et de diagnostic sont typiquement mises en oeuvre à partir de mesures de grandeurs électriques réalisées par les appareils auxiliaires, comme par exemple décrit dans le document EP-2849196-B1. D'autres exemples peuvent être décrits par les documents FR-3010531-A1 et FR-3010584-A1.

Toutefois, dans certaines circonstances, les diagnostics effectués par les appareils auxiliaires peuvent être erronés.

C'est à ces inconvénients qu'entend plus particulièrement remédier l'invention en proposant un procédé de diagnostic de la cause de déclenchement d'un appareil de protection électrique, ainsi qu'un appareil auxiliaire et un système électrique pour la mise en oeuvre d'un tel procédé de diagnostic.

A cet effet, l'invention concerne un procédé de diagnostic de la cause de déclenchement d'un appareil de protection électrique conforme à la revendication 1.

Grâce à l'invention, la cause de déclenchement de l'appareil de protection peut être diagnostiquée par un appareil auxiliaire indépendant de l'appareil de protection.

L'implémentation de la fonction de diagnostic sur des installations existantes est donc facilitée, puisque cette fonction peut être intégrée simplement en ajoutant l'appareil auxiliaire et sans avoir besoin de remplacer tout ou partie des appareils de protection.

En outre, la fiabilité du diagnostic de la cause du déclenchement est améliorée.

Selon des aspects avantageux mais non obligatoires de l'invention, un tel procédé de diagnostic peut incorporer une ou plusieurs des caractéristiques suivantes, prises isolément ou suivant toute combinaison techniquement admissible :
- Lors du calcul de la première valeur de seuil, les valeurs enregistrées de l'intensité maximale du courant qui sont associées à des intervalles de temps postérieurs à l'intervalle de temps correspondant à la plus grande valeur déterminée de l'intensité maximale du courant sont ignorées pour la détermination de la plus petite valeur, la plus petite valeur de l'intensité maximale du courant étant déterminée parmi les seules valeurs enregistrées correspondant aux intervalles de temps antérieurs à l'intervalle de temps correspondant à la plus grande valeur déterminée.
- Lors de la détermination d'un type de défaut électrique, aucun court-circuit n'est diagnostiqué si la plus grande valeur déterminée de l'intensité maximale du courant est inférieure à deux fois la plus petite valeur déterminée de l'intensité maximale du courant.
- Lors de la détermination d'un type de défaut électrique, un court-circuit n'est diagnostiqué que si, en plus, la plus grande valeur de l'intensité maximale du courant parmi les valeurs enregistrées pour plusieurs intervalles de temps précédant la perte de l'alimentation électrique est supérieure ou égale à deux fois la valeur de courant de calibre de l'appareil de protection.
- La deuxième valeur de seuil est supérieure à la valeur de courant de calibre et inférieure à deux fois ladite valeur de courant de calibre de l'appareil de protection.
- Lorsque la détermination d'un type de défaut électrique a conduit à la détection à la fois d'un court-circuit et d'une surcharge, seule la détection du court-circuit est prise en compte, la détection de la surcharge étant alors dans ce cas automatiquement ignorée.
- Le procédé comporte, lors de la détection d'un défaut électrique de type courant de surcharge, l'enregistrement, dans une mémoire de l'appareil auxiliaire, de la plus grande valeur de valeur efficace du courant.
- Le procédé comporte, postérieurement à la détermination du type de défaut électrique, l'envoi d'un message de diagnostic représentatif du type de défaut électrique déterminé, à destination d'un concentrateur, au moyen d'une interface de communication sans fil de l'appareil auxiliaire et/ou l'enregistrement, dans une mémoire de l'appareil auxiliaire, d'une information de diagnostic représentative du type de défaut électrique déterminé.
- La durée des intervalles de temps est proportionnelle à la période du courant électrique alternatif circulant dans ledit conducteur électrique.

Selon un autre aspect, l'invention concerne un appareil auxiliaire pour une installation électrique comprenant un appareil de protection électrique associé à au moins un conducteur électrique, l'appareil auxiliaire comportant un capteur de courant associé au conducteur électrique, une unité électronique de traitement et au moins une mémoire, l'appareil électrique étant configuré pour mettre en oeuvre un procédé de diagnostic de la cause de déclenchement de l'appareil de protection électrique conforme à tel que décrit précédemment.

Selon encore un autre aspect, l'invention concerne un système électrique comportant un appareil de protection électrique et un appareil auxiliaire associés à au moins un conducteur électrique d'une installation électrique, l'appareil de protection électrique étant adapté pour interrompre la circulation d'un courant électrique dans le conducteur électrique en cas de détection d'un défaut électrique, l'appareil auxiliaire étant conforme à ce qui est décrit précédemment.

L'invention sera mieux comprise et d'autres avantages de celle-ci apparaîtront plus clairement à la lumière de la description qui va suivre, d'un mode de réalisation d'un procédé de diagnostic donnée uniquement à titre d'exemple et faite en référence aux dessins annexés, dans lesquels :
- la figure 1 est une représentation schématique d'une installation électrique comportant un système électrique selon des modes de réalisation de l'invention ;
- la figure 2 est une représentation schématique d'une chaîne de mesure d'un module auxiliaire du système électrique de la figure 1 ;
- la figure 3 est une représentation schématique d'une unité électronique de traitement utilisée dans la chaîne de mesure de la figure 2 ;
- la figure 4 est un ordinogramme d'un procédé de mesure d'un courant électrique par la chaîne de mesure de la figure 2 ;
- la figure 5 est un graphique représentant la valeur d'intensité d'un courant électrique mesuré en fonction du temps par la chaîne de mesure de la figure 2 préalablement à une interruption du courant ;
- la figure 6 est un ordinogramme d'un procédé de diagnostic pour détecter si une interruption du courant dans le système électrique de la figure 1 est due à un court-circuit ;
- la figure 7 est un ordinogramme d'un procédé de diagnostic pour détecter si une interruption du courant dans le système électrique de la figure 1 est due à une surcharge ;
- la figure 8 est un ordinogramme illustrant une variante du procédé de diagnostic des figures 6 et 7.

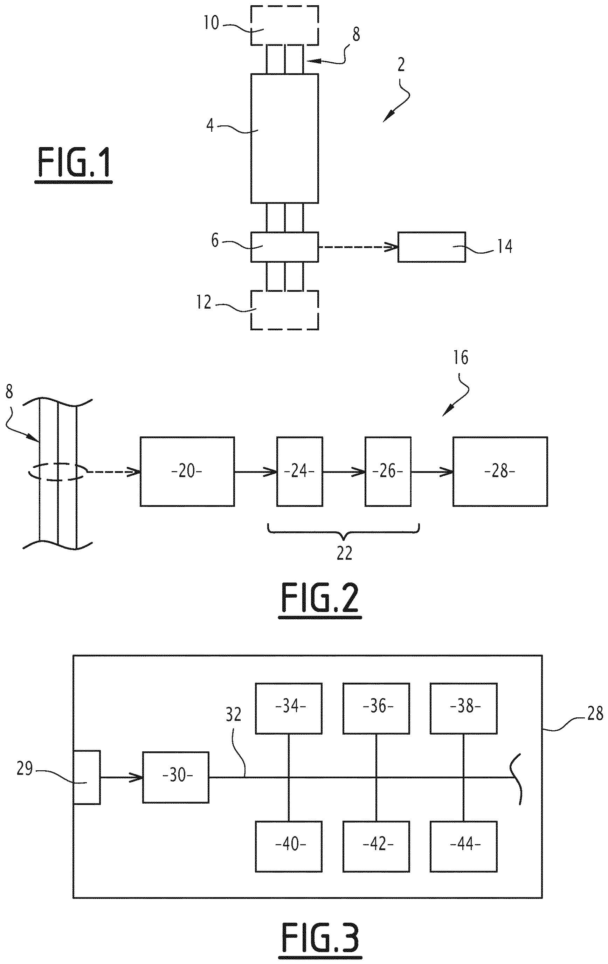

La figure 1 représente une installation électrique 2 comportant un appareil de protection électrique 4 et un appareil auxiliaire 6. Un ou plusieurs conducteurs électriques 8 raccordent électriquement une source électrique 10 à une charge électrique 12.

L'appareil de protection 4 et l'appareil auxiliaire 6 sont associés aux conducteurs électriques 8 de l'installation 2.

A titre d'exemple illustratif, la source 10 comporte un générateur ou un réseau de type secteur.

Par exemple, l'installation électrique 2 est une installation de distribution d'électricité. Le ou les conducteurs 8 permettent d'acheminer un courant électrique alternatif entre la source 10 et la charge 12.

Selon des modes de réalisation, l'installation 2 peut être une installation monophasée ou polyphasée.

Dans l'exemple illustré, trois conducteurs 8 sont illustrés, par exemple pour former un réseau triphasé apte à acheminer un courant électrique triphasé.

Toutefois, pour simplifier la description, les modes de réalisation ne sont décrits qu'en référence à un seul pôle ou phase de l'installation 2. On comprend néanmoins que ce qui sera décrit dans ce qui suit peut être transposé à chacun des autres pôles ou phases de l'installation 2 et peut être généralisé à d'autres cas de figure non expressément décrits, tel qu'un réseau monophasé ou un réseau à quatre pôles (triphasé avec neutre).

Selon des exemples, l'appareil de protection 4 est un disjoncteur ou tout appareil de protection électrique équivalent.

L'appareil 4 est connecté en série avec les conducteurs 8 et permet d'interrompre la circulation du courant électrique dans les conducteurs 8, notamment en cas de détection d'un défaut électrique dans l'installation 2, tel qu'un court-circuit ou une surcharge, survenant sur une ou plusieurs des phases de l'installation 2.

A cet effet, l'appareil 4 comporte un déclencheur, non illustré, pour détecter un tel défaut électrique et, en réponse, forcer la commutation de l'appareil 4 vers un état électriquement ouvert pour interrompre la circulation du courant.

Selon différents modes de réalisation, le déclencheur est mis en oeuvre grâce à un dispositif électronique ou grâce à un dispositif thermomagnétique.

Selon des exemples, l'appareil 4 comporte également un organe de commande, tel qu'un levier, actionnable par un utilisateur de l'appareil 4, pour commuter manuellement l'appareil 4 entre ses états ouvert et fermé.

L'appareil auxiliaire 6 est associé à l'appareil 4 pour mettre en oeuvre des fonctions de surveillance et de supervision de l'installation 2 et de l'appareil 4.

L'appareil 4 et l'appareil 6 forment ensemble un système électrique.

L'appareil 6 est ici couplé aux conducteurs 8, par exemple en étant placé en aval de l'appareil 4.

Selon des modes de réalisation, les constituants de l'appareil auxiliaire 6 sont logés dans un boîtier distinct de celui de l'appareil 4. Les appareils 4 et 6 sont par exemple montés sur un tableau électrique ou dans une armoire électrique.

Selon des modes de mise en oeuvre avantageux mais néanmoins optionnels, l'appareil auxiliaire 6 est également apte à communiquer par une liaison sans fil avec un concentrateur radio 14 placé à proximité de l'installation 2.

L'appareil 6 est notamment adapté pour mesurer l'intensité du courant électrique dans un ou plusieurs conducteurs 8 de l'installation 2 et comporte à cet effet un ou plusieurs capteurs de courant.

De préférence, chaque capteur de courant est associé à une des phases de l'installation 2 et donc à un des conducteurs 8.

La figure 2 représente un exemple de chaîne de mesure 16 implémentée par l'appareil 6 pour mesurer le ou les courants électriques.

L'appareil 6 comporte notamment un capteur de courant 20 associé à un conducteur 8.

Selon des modes de réalisation, le capteur de courant 20 comporte un tore de Rogowski, ou un capteur à effet Hall, ou un shunt de mesure, ou tout autre capteur de courant équivalent.

Dans l'exemple illustré, l'appareil 6 comporte en outre un circuit d'acquisition 22 du signal mesuré, qui comporte par exemple un circuit de conditionnement 24 et un convertisseur analogique-numérique 26.

Le circuit de conditionnement 24 permet par exemple d'assurer des fonctions de filtrage et/ou d'amplification et/ou d'isolement électrique du signal mesuré en amont du convertisseur 26.

L'appareil 6 comporte également une unité électronique de traitement 28 embarquée configurée pour mettre en oeuvre un procédé de diagnostic de la cause de déclenchement de l'appareil 4 en fonction des mesures de courant réalisées par le ou les capteurs 20.

La chaîne de mesure 16 est ici décrite en référence à une seule phase de l'installation 2, mais on comprend que les mesures de courant peuvent être réalisées indépendamment pour chacune des phases. L'appareil 6 comporte autant de capteurs 20 que nécessaire, par exemple autant de capteurs 20 que de conducteurs 8 à surveiller. Certains composants de l'appareil 6, notamment l'unité de traitement 28, sont de préférence communs à plusieurs chaînes de mesure 16. L'appareil 6 comporte ici une unité de traitement 28.

La figure 3 représente un exemple de l'unité de traitement 28.

L'unité 28 comporte une entrée 29 pour recevoir un signal de mesure délivré par un capteur 20. Par exemple, l'entrée 29 est connectée à la sortie du convertisseur 26.

L'unité 28 comporte également un processeur logique 30 (abrévié CPU, de l'anglais « Central Processing Unit ») et comporte aussi, raccordées au processeur 30 par un bus de données interne 32, une ou plusieurs mémoires informatiques 34, 36, 38, 40, une interface de commande utilisateur 42 et une interface de communication sans fil 44.

En variante, l'unité 28 peut être réalisée différemment, par exemples en omettant les interfaces 42 et/ou 44.

Selon des exemples, le processeur 30 est un microcontrôleur programmable ou un microprocesseur ou un processeur dédié de traitement du signal (abrévié DSP, de l'anglais « Digital Signal Processor »). En variante, l'unité de traitement 28 comporte un composant logique programmable de type FPGA ou un circuit intégré dédié.

Le processeur 30 est connecté à l'entrée 29 et reçoit les signaux de mesure envoyés vers l'entrée 29 par la chaîne de mesure 16.

Selon des modes de mise en oeuvre, la mémoire est une mémoire ROM, ou une mémoire RAM, ou une mémoire non volatile de type EPROM, ou EEPROM, ou FLASH, ou NVRAM, ou une mémoire optique ou magnétique. Par exemple, les mémoires forment des supports de stockage d'information non transitoires et lisibles par ordinateur.

Selon des exemples, la mémoire 34 comporte des instructions exécutables et/ou un code logiciel pour mettre en oeuvre un procédé de diagnostic tel que décrit dans ce qui suit lorsque ces instructions et/ou ce code sont exécutées et/ou interprétées par le processeur 30.

Les mémoires 36 et 38 forment ici des première et deuxième mémoires tampon, respectivement. De préférence, les mémoires 36 et 38 sont des mémoires tampon circulaires (« circular buffer » en langue anglaise) notamment aptes à stocker un nombre prédéfini de valeurs numériques.

La mémoire 40 permet de stocker des données, par exemple en vue d'un accès ultérieur par un utilisateur. Ces données peuvent inclure une information représentative d'un diagnostic réalisé par l'unité 28 selon le procédé décrit ci-après.

Dans l'exemple de la figure 3, les mémoires 34, 36, 38 et 40 sont illustrées comme étant distinctes pour simplifier la description, mais en pratique d'autres constructions sont possibles et les mémoires ne sont pas forcément physiquement séparées. Par exemple, les mémoires 34, 36, 38 et 40 peuvent être implémentées dans une même mémoire physique de l'unité 26. Les mémoires tampon 36 et 38 peuvent être implémentées par des structures de données enregistrées au sein d'une même mémoire physique. Les mémoires 34 et 40 peuvent être implémentées sur une même mémoire physique.

Selon des exemples, l'interface 42 permet d'échanger des informations entre l'unité 28 et un utilisateur extérieur. L'interface 42 peut ainsi comporter un ou plusieurs des dispositifs suivants : un indicateur lumineux, un écran d'affichage, un connecteur de données.

Selon des modes de réalisation, l'interface 44 comporte un circuit émetteur-récepteur et une antenne radio couplée au circuit émetteur-récepteur.

Selon des exemples, l'appareil 6 peut également comporter des moyens d'alimentation en énergie électrique, non illustrés, tels qu'une réserve d'énergie de type batterie ou un transformateur de courant couplé aux conducteurs 8.

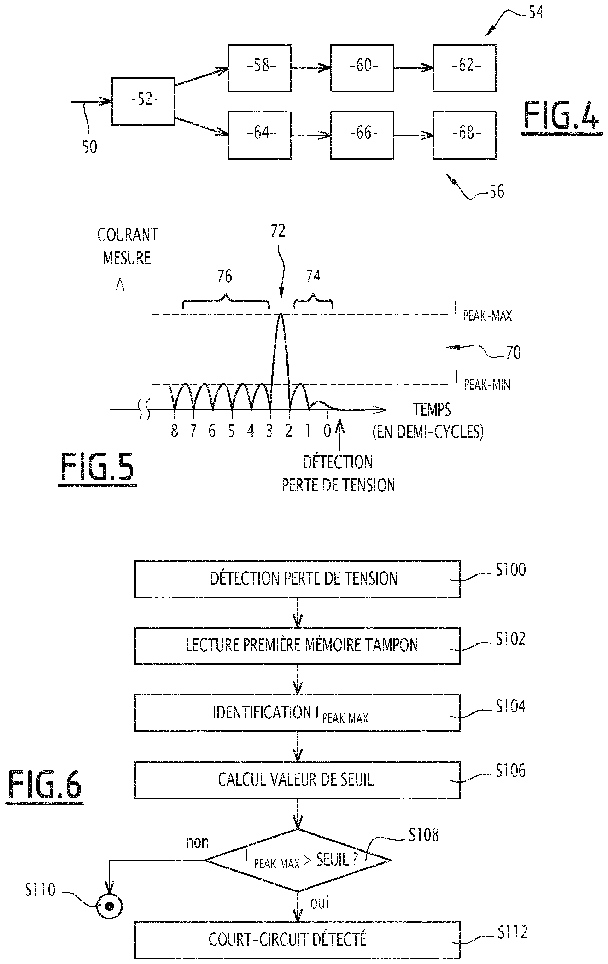

La figure 4 représente un exemple de fonctionnement de l'appareil auxiliaire 6 et de l'unité 28 lorsqu'un courant électrique alternatif est présent dans le conducteur 8 surveillé, par exemple avant un déclenchement de l'appareil de protection 4.

D'abord, l'appareil 6 mesure l'intensité du courant électrique alternatif circulant dans le conducteur électrique 8, grâce au capteur 20 et à la chaîne de mesure 16.

La flèche 50 représente un signal de mesure du courant reçu sur l'entrée 29. Par exemple, le signal de mesure reçu est un signal échantillonné qui provient du convertisseur 26.

Selon un exemple illustratif et non nécessairement limitatif, la fréquence d'échantillonnage du signal mesuré est choisie égale à 2kHz, ce qui correspond à 40 échantillons par cycle de 50Hz.

Selon des variantes, la fréquence d'échantillonnage peut être différente. En pratique, la fréquence d'échantillonnage est généralement choisie en fonction de la fréquence du courant alternatif.

Dans certains cas, selon le type de capteur 20 utilisé, le signal reçu est représentatif de la dérivée temporelle du courant. C'est notamment le cas lorsque le capteur 20 est un tore de Rogowski. Dans ce cas, lors d'une étape 52, l'unité 28 implémente une intégration numérique des valeurs reçues pour obtenir une valeur directement représentative de l'intensité. L'étape 52 est omise lorsque le capteur 20 fournit directement une valeur représentative de l'intensité instantanée.

Ensuite, l'unité 28 calcule automatiquement des valeurs représentatives du courant électrique mesuré, lesdites valeurs représentatives étant chacune calculées à partir des valeurs d'intensité mesurées pendant un intervalle de temps prédéfini.

Les valeurs calculées sont ensuite enregistrées en mémoire 36, 38 de l'appareil 6.

La mesure, le calcul et l'enregistrement sont réalisés de façon répétée et/ou continue tant qu'un courant électrique circule dans ledit conducteur électrique 8.

Plusieurs types de valeurs représentatives du courant électrique peuvent être calculés à partir des valeurs mesurées. Les intervalles de temps peuvent présenter une durée particulière pour chaque type de valeur représentative.

Selon des modes de mise en oeuvre, les valeurs représentatives du courant électrique incluent l'intensité maximale du courant mesuré, notée I_{PEAK}, et la valeur efficace du courant mesuré, notée I_{RMS}, aussi nommée moyenne quadratique (« RMS » en langue anglaise).

Plusieurs valeurs d'intensité maximale I_{PEAK} sont calculées respectivement pour plusieurs premiers intervalles de temps successifs, à partir des valeurs d'intensité mesurées par le capteur 20 pendant chacun de ces premiers intervalles de temps.

Plusieurs valeurs de valeur efficace I_{RMS} sont calculées respectivement pour plusieurs deuxièmes intervalles de temps successifs, à partir des valeurs d'intensité mesurées par le capteur 20 pendant chacun de ces deuxièmes intervalles de temps.

Les calculs et l'enregistrement sont, par exemple, réalisés en parallèle et indépendamment l'un de l'autre pour ces deux types de valeurs représentatives du courant électrique, comme illustré par les deux branches 54 et 56 de la figure 4.

Selon des exemples, la durée des intervalles de temps est proportionnelle à la période du courant électrique alternatif circulant dans ledit conducteur électrique 8.

Par exemple, pour une installation électrique 2 fonctionnant à une fréquence nominale de 50Hz, la période du courant électrique alternatif est égale à 20ms.

A titre d'exemple illustratif et non nécessairement limitatif, chaque premier intervalle de temps a une durée égale à une demi-période du courant électrique et chaque deuxième intervalle de temps a une durée égale à deux périodes. Ces valeurs peuvent être choisies différemment, notamment en fonction des propriétés de l'installation 2 ou de la source 10.

De préférence, les premier et deuxièmes intervalles de temps sont synchronisés avec les alternances périodiques du courant électrique alternatif mesuré, par exemple de telle sorte que chaque premier intervalle de temps coïncide avec un demi-cycle d'oscillation du courant électrique alternatif mesuré. Ainsi, selon ces exemples, le début de chaque premier ou deuxième intervalle de temps coïncide avec un passage par zéro du courant électrique alternatif. Par exemple, le courant électrique alternatif circulant dans le conducteur 8 a une forme sinusoïdale.

Dans l'exemple illustré, le calcul de chaque valeur efficace I_{RMS} comporte une étape 58 d'accumulation des valeurs de mesure échantillonnées dans une mémoire de travail de l'unité 28, par exemple dans la mémoire 34. Puis, une fois que des valeurs mesurées ont été accumulées pendant une durée égale au deuxième intervalle de temps, alors la valeur efficace I_{RMS} correspondante est calculée automatiquement par le processeur 30, lors d'une étape 60, à partir des valeurs accumulées. Les valeurs accumulées peuvent ensuite être réinitialisées.

Ensuite, lors d'une étape 62, la valeur efficace I_{RMS} calculée est enregistrée dans la deuxième mémoire tampon 38. Dans l'exemple illustré, la mémoire tampon 38 peut stocker au moins cinq valeurs de valeur efficace I_{RMS} et les valeurs les plus anciennes sont supprimées lorsqu'une nouvelle valeur est enregistrée.

En parallèle, dans l'exemple illustré, le calcul de chaque valeur d'intensité maximale I_{PEAK} comporte une étape 64 de détection d'une alternance du courant électrique alternatif mesuré.

Une fois l'alternance détectée, l'unité 28 décompte une durée correspondant au premier intervalle de temps puis, lors d'une étape 66, calcule automatiquement la valeur d'intensité maximale I_{PEAK}, ou valeur de pic, parmi les valeurs d'intensité mesurées pour cette durée.

Ensuite, lors d'une étape 68, la valeur calculée d'intensité maximale I_{PEAK} est enregistrée dans la première mémoire tampon 36.

Dans l'exemple illustré, la mémoire tampon 36 peut stocker au moins huit valeurs d'intensité maximale I_{PEAK} et les valeurs les plus anciennes sont supprimées lorsqu'une nouvelle valeur est enregistrée.

Selon des variantes, la taille des mémoires tampon 36 et 38 peut être supérieure à celle indiquée. Par exemple, chaque mémoire tampon 36 et 38 permet de stocker au moins 10 valeurs ou au moins 20 valeurs calculées. Plus les mémoires tampon 36 et 38 sont grandes, le procédé de détection est fiable, car le diagnostic est alors basé sur un plus grand nombre de valeurs enregistrées, comme on le comprendra dans ce qui suit.

En pratique, le choix de la taille mémoires 36 et 38 résulte d'un compromis entre les exigences de fiabilité du diagnostic et les limitations matérielles de l'unité 28.

Un exemple de mise en oeuvre par l'unité 28 d'un procédé de diagnostic de la cause de déclenchement de l'appareil 4 est maintenant décrit en référence aux figures 5, 6, 7 et 8. Comme expliqué précédemment, ce procédé est décrit en référence à une seule phase de l'installation 2.

D'abord, l'appareil 4 est déclenché et interrompt la circulation du courant électrique dans le conducteur électrique 8 surveillé.

Par exemple, le déclenchement est causé par la détection, par le déclencheur, d'un défaut électrique sur l'installation 2, tel qu'un court-circuit ou une surcharge.

Lors d'une étape S100, l'appareil 6 détecte automatiquement la perte d'alimentation électrique dans le conducteur 8. Dans ce qui suit, les expressions « perte de tension » et « perte d'alimentation » sont utilisées de façon interchangeable.

Par exemple, un dispositif de détection, tel qu'un capteur de tension dans l'appareil 6, non illustré, détecte une perte de la tension entre le conducteur 8 et un potentiel de référence. En variante, la détection de perte d'alimentation est réalisée grâce aux mesures du capteur 20.

Dans certains modes de réalisation, à ce stade, les étapes de mesure, de calcul et d'enregistrement précédemment décrites peuvent être interrompues.

Ensuite, l'unité 28 détermine automatiquement le type de défaut électrique qui est à l'origine du déclenchement de l'appareil 4 à partir des valeurs calculées enregistrées dans les mémoires 36 et 38.

Selon des modes de réalisation, l'unité 28 met en oeuvre un premier procédé pour déterminer si le défaut électrique est un court-circuit et met en oeuvre, en parallèle, un deuxième procédé pour déterminer si le défaut électrique est une surcharge.

Par exemple, dans le premier procédé, l'unité 28 compare, avec une première valeur de seuil, la plus grande valeur I_{PEAK-MAX} de l'intensité maximale du courant I_{PEAK} parmi les valeurs I_{PEAK} enregistrées pour plusieurs intervalles de mesure précédant la perte de l'alimentation électrique, un court-circuit étant diagnostiqué si la plus grande valeur de l'intensité maximale est supérieure à la première valeur de seuil.

Ainsi, comme illustré sur l'exemple de la figure 6, suite à l'étape S100 de détection de la perte d'alimentation, les valeurs I_{PEAK} précédemment calculées et stockées en mémoire sont lues lors d'une étape S102, puis la valeur maximale I_{PEAK-MAX} de toutes ces valeurs I_{PEAK} est identifiée automatiquement lors d'une étape S104.

Avantageusement, la première valeur de seuil est calculée automatiquement, postérieurement à la détection de perte d'alimentation électrique, ici lors d'une étape S106 postérieure aux étapes S102 et S104, en fonction des valeurs I_{PEAK} préalablement enregistrées dans la mémoire 36.

Selon des modes de réalisation, lors de l'étape S106, le calcul de la première valeur de seuil comporte la détermination de la plus grande valeur I_{PEAK-MAX} et de la plus petite valeur I_{PEAK-MIN} de l'intensité I_{PEAK} parmi les valeurs enregistrées dans la mémoire tampon 36. Par exemple, la plus grande valeur I_{PEAK-MAX} est celle déterminée lors de l'étape S102.

Ensuite, la valeur moyenne entre la plus petite valeur I_{PEAK-MIN} et la plus grande valeur I_{PEAK-MAX} précédemment déterminées est calculée automatiquement, par exemple au moyen de la formule (I_{PEAK-MAX}+ I_{PEAK-MIN})/2, la première valeur de seuil étant définie égale à cette valeur moyenne calculée.

En référence au calcul de la première valeur de seuil, la figure 5 représente schématiquement, à des fins d'explication, une courbe 70 illustrant l'évolution du courant électrique alternatif pour les instants précédant la perte d'alimentation électrique.

Sur la figure 5, l'axe des abscisses correspond au temps, exprimé en demi-cycles numérotés consécutivement de façon décroissante jusqu'à la perte d'alimentation électrique. L'axe des ordonnées correspond à l'intensité du courant, exprimée en unités arbitraires. Seuls huit demi-cycles sont représentés en abscisse, correspondant aux huit valeurs I_{PEAK} enregistrées dans la première mémoire tampon 36. Pour chaque demi-cycle, la valeur maximale du courant correspond à la valeur I_{PEAK} enregistrée dans la première mémoire tampon 36. De préférence, les demi-cycles correspondent aux premiers intervalles de temps.

La référence 72 désigne un intervalle de temps pour lequel le courant présente une valeur maximale. Par exemple, cette valeur maximale correspond au défaut électrique à l'origine du déclenchement et survient avant la détection de la perte d'alimentation. En pratique, lorsqu'un défaut électrique survient dans l'installation 2, le déclenchement de l'appareil 4 n'est pas instantané et il s'écoule un certain délai entre la mesure du défaut électrique et la détection de perte d'alimentation par le module 6. On constate ici qu'après le pic de courant observé pour l'intervalle 72, le courant alternatif diminue en amplitude et finit par devenir nul.

La référence 74 désigne des intervalles de temps postérieurs à l'intervalle de temps 72 et antérieurs à la détection de perte d'alimentation.

La référence de temps 76 désigne les intervalles de temps antérieurs à l'intervalle 72 et pour lesquels des valeurs I_{PEAK} sont enregistrées dans la première mémoire tampon 36.

Selon des modes de mise en oeuvre avantageux mais néanmoins optionnels de l'étape S106, les valeurs I_{PEAK} enregistrées dans la première mémoire tampon 36 qui sont associées aux intervalles 74 postérieurs à l'intervalle 72 correspondant à la plus grande valeur I_{PEAK-MAX} sont ignorées pour la détermination de la plus petite valeur I_{PEAK-MIN}.

Ainsi, la plus petite valeur I_{PEAK-MIN} est déterminée parmi les seules valeurs I_{PEAK} enregistrées en mémoire 36 qui correspondent aux intervalles 76 antérieurs à l'intervalle 72. Cela permet d'éviter que des variations parasites du courant soient prises en compte dans le calcul de la première valeur de seuil. En effet, dans certains cas, lorsque l'installation 2 est connectée à certains types de charge électrique 12, notamment des charges inductives telles que des moteurs électriques, une tension électrique résiduelle peut être présente entre des conducteurs 8 en aval de l'appareil 4 après le déclenchement de l'appareil 4. Cela permet donc d'obtenir un diagnostic plus fiable.

Selon des variantes optionnelles du premier procédé, aucun court-circuit n'est diagnostiqué si la plus grande valeur I_{PEAK-MAX} est inférieure à deux fois la plus petite valeur I_{PEAK-MIN}. En d'autres termes, si, à l'issue de l'étape S106, la plus grande valeur I_{PEAK-MAX} est inférieure à deux fois la plus petite valeur I_{PEAK-MIN}, alors le premier procédé est interrompu sans qu'un court-circuit ne soit diagnostiqué. Cela permet d'éviter de diagnostiquer par erreur un court-circuit dans un cas où le courant électrique fluctue autour de la valeur du courant proche du courant de surcharge. Cela permet donc d'obtenir un diagnostic plus fiable.

Selon diverses variantes, la première valeur de seuil peut être calculée différemment. La première valeur de seuil peut aussi être une valeur prédéfinie qui n'est pas recalculée par la suite. Dans ce cas, l'étape S106 est omise.

De retour à la figure 6, lors d'une étape S108 postérieure à l'étape S104 et, le cas échéant postérieure à l'étape S106, l'unité 28 compare automatiquement la valeur I_{PEAK-MAX} avec la première valeur de seuil.

Si la valeur I_{PEAK-MAX} est inférieure ou égale à la première valeur de seuil, alors aucun court-circuit n'est détecté et le premier procédé prend fin lors d'une étape S110.

Si la valeur I_{PEAK-MAX} est supérieure à la première valeur de seuil, alors un court-circuit est dit être détecté et le premier procédé prend fin lors d'une étape S112.

En d'autres termes, il suffit ici qu'une ou deux valeurs I_{PEAK} enregistrées en mémoire 36 soient supérieures à la première valeur de seuil pour qu'un court-circuit soit diagnostiqué.

Selon des modes de mise en oeuvre optionnels, un court-circuit n'est diagnostiqué que si, en plus, la plus grande valeur I_{PEAK-MAX} est supérieure ou égale à deux fois la valeur de courant de calibre Iₙ de l'appareil de protection 4. Par exemple, la valeur de courant de calibre Iₙ de l'appareil de protection 4 est préalablement renseignée en mémoire 34 de l'unité 28. Une telle comparaison est par exemple mise en oeuvre pendant l'étape S108 ou conjointement à l'étape S108 ou après l'étape S108.

Grâce à cette condition supplémentaire, on évite de diagnostiquer par erreur un court-circuit dans un cas où le courant électrique fluctue autour de petites valeurs d'intensité. La fiabilité du diagnostic est ainsi améliorée.

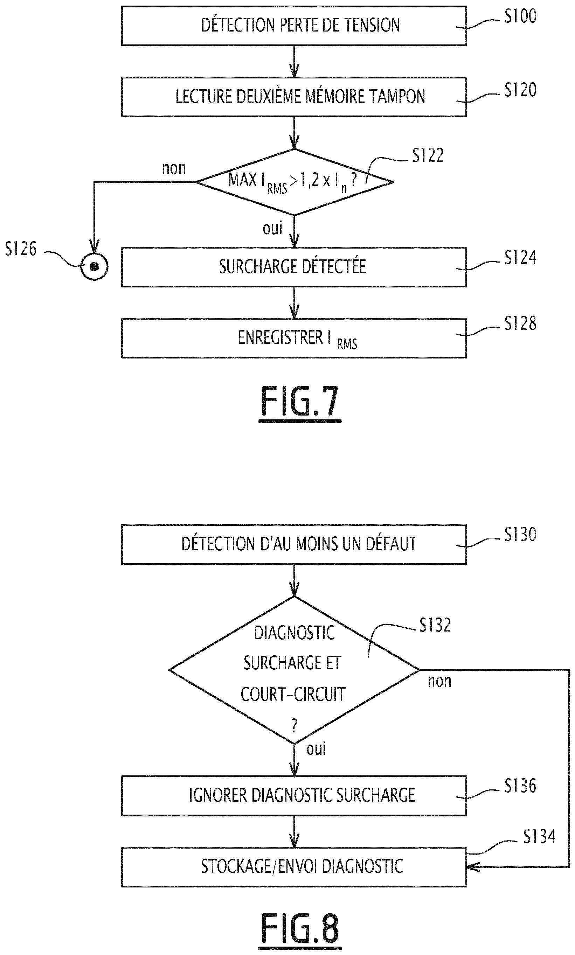

En parallèle, dans le deuxième procédé, comme illustré sur la figure 7, l'unité 28 compare, avec une deuxième valeur de seuil, la plus grande valeur de valeur efficace du courant I_{RMS} parmi les valeurs enregistrées pour plusieurs intervalles de mesure précédant la perte de l'alimentation électrique, une surcharge étant diagnostiquée si la plus grande valeur de valeur efficace est supérieure à la deuxième valeur de seuil.

Selon des modes de réalisation, la deuxième valeur de seuil est choisie supérieure à la valeur de courant de calibre Iₙ de l'appareil de protection 4 et inférieure à deux fois ladite valeur de courant de calibre Iₙ. De préférence, la deuxième valeur de seuil est égale à 1,2 fois la valeur de courant de calibre Iₙ. Par exemple, la valeur de courant de calibre Iₙ de l'appareil de protection 4 est préalablement renseignée en mémoire 34 de l'unité 28.

Ainsi, suite à l'étape S100 de détection de perte d'alimentation, les valeurs efficaces I_{RMS} stockées dans la deuxième mémoire tampon 38 sont lues lors d'une étape S120, puis la valeur maximale I_{RMS-MAX} de toutes ces valeurs efficaces I_{RMS} enregistrées est identifiée automatiquement.

Lors d'une étape S122 postérieure à l'étape S120, l'unité 28 compare automatiquement la valeur maximale I_{RMS-MAX} avec la deuxième valeur de seuil.

Si la valeur maximale I_{RMS-MAX} est supérieure à la deuxième valeur de seuil, alors une surcharge est diagnostiquée lors d'une étape S124.

Si la valeur maximale I_{RMS-MAX} est inférieure ou égale à la deuxième valeur de seuil, alors aucune surcharge n'est détectée et le deuxième procédé prend fin lors d'une étape S 126.

Avantageusement, si une surcharge est diagnostiquée lors de l'étape S124, alors la valeur maximale I_{RMS-MAX} correspondante est enregistrée dans la mémoire 40 de l'unité 28 lors d'une étape S128.

Ainsi, à l'issue des premier et deuxième procédés, il est possible de disposer d'une information de diagnostic sur la cause du déclenchement de l'appareil 4 à l'origine de la perte d'alimentation électrique, notamment pour savoir si ce déclenchement est causé par un court-circuit ou par une surcharge.

Dans les cas où aucun des procédés n'a permis d'identifier la cause comme étant un court-circuit ou une surcharge, il est possible que le déclenchement ait été causé par une action manuelle d'un utilisateur sur le levier de commande de l'appareil 4.

Selon des modes de réalisation non illustrés, postérieurement à l'établissement d'un diagnostic (par exemple à la fin des étapes S110 ou S112 et S124 ou S126), un message de diagnostic représentatif du type de défaut électrique diagnostiqué est envoyé par l'appareil 6.

Par exemple, le message de diagnostic est envoyé à destination du concentrateur radio 14, au moyen de l'interface de communication sans fil 44. Selon des exemples, le concentrateur radio 14 est configuré pour relayer le message reçu vers un serveur informatique distant, par exemple au moyen d'une liaison radio longue portée ou par le biais d'un réseau informatique, tel qu'un réseau local ou le réseau internet.

A la place et/ou de façon complémentaire, une information de diagnostic représentative du type de défaut électrique diagnostiqué est enregistrée dans une mémoire 40 de l'appareil auxiliaire 6.

Par exemple, l'information de diagnostic stockée en mémoire peut être consultée par un utilisateur au moyen de l'interface 42. Selon des exemples, la cause de déclenchement diagnostiquée est affichée au moyen d'un écran ou d'un témoin lumineux de l'interface 42.

Selon des modes de mise en oeuvre optionnels, illustrés sur la figure 8, lorsqu'au moins un défaut électrique de type court-circuit ou surcharge a été diagnostiqué à l'issue des premier et/ou deuxième procédés (étape S130), l'unité 28 vérifie automatiquement, lors d'une étape S132, si deux défauts de type court-circuit et surcharge ont été diagnostiqués.

Si un seul défaut électrique de type court-circuit et surcharge a été diagnostiqué, alors le diagnostic est validé lors d'une étape S134 et peut être envoyé et/ou stocké comme précédemment décrit.

Si deux défauts de type court-circuit et surcharge ont été diagnostiqués, alors le diagnostic est corrigé lors d'une étape S136, afin d'ignorer le diagnostic de surcharge et afin de ne conserver que le diagnostic de court-circuit.

En d'autres termes, lorsque la détermination d'un type de défaut électrique a conduit à la détection à la fois d'un court-circuit et d'une surcharge, seule la détection du court-circuit est prise en compte, la détection de la surcharge étant alors dans ce cas automatiquement ignorée.

Dans cet exemple, lors de l'étape S136, les informations de diagnostic qui ont pu être enregistrées en mémoire 40 à la fin de l'exécution du deuxième procédé lors de l'étape S128, sont automatiquement effacées.

Ignorer le diagnostic de surcharge dans le cas où deux causes sont simultanément diagnostiquées permet d'obtenir un diagnostic plus fiable. En effet, lorsqu'un court-circuit se produit, une surcharge peut être accidentellement diagnostiquée même si un court-circuit a été correctement diagnostiqué.

L'invention permet de diagnostiquer la cause de déclenchement de l'appareil de protection 4 grâce à l'appareil auxiliaire 6. L'appareil 6 est indépendant du déclencheur de l'appareil 4 et le diagnostic est réalisé sans avoir besoin de connaître l'état du déclencheur de l'appareil 4. L'implémentation de la fonction de diagnostic sur des installations électriques existantes est donc facilitée, puisqu'une telle fonction peut être intégrée simplement en associant l'appareil auxiliaire 6 aux conducteurs 8 et sans avoir besoin de remplacer tout ou partie des appareils de protection de l'installation 2.

De plus, les modes de réalisation des procédés décrits ci-dessus permettent d'effectuer un diagnostic plus fiable de la cause du déclenchement de l'appareil 4 que certaines méthodes implémentées par des appareils de mesure.

En effet, certaines méthodes de diagnostic de la cause de déclenchement mises en oeuvre par des appareils auxiliaires et basées sur la mesure de la forme d'onde du courant alternatif mesuré présentent un risque de détection erronée dans certaines circonstances, notamment en cas de saturation du capteur de courant, car la forme d'onde du signal mesuré dans un tel cas peut faussement être confondue avec la signature d'un courant de surcharge dans l'installation 2. Ce n'est pas le cas grâce à l'invention, grâce au fait que l'identification de la cause du défaut électrique est basée sur des valeurs représentatives spécifiques qui ont fait l'objet d'un calcul.

De plus, avec ces méthodes, il existe un risque que le diagnostic ne puisse pas être réalisé si le déclenchement survient peu de temps après le démarrage de l'appareil auxiliaire chargé de la mesure si le procédé de détection n'a pas eu le temps de s'initialiser complètement.

Ce n'est pas le cas grâce à l'invention, notamment grâce au fait que l'identification de la cause du défaut électrique est basée sur des valeurs représentatives du courant mesuré qui ont été préalablement enregistrées pour plusieurs intervalles de temps précédant la perte d'alimentation.

Les modes de réalisation et les variantes envisagés ci-dessus peuvent être combinés entre eux pour générer de nouveaux modes de réalisation.

## Revendications

1. Procédé de diagnostic de la cause de déclenchement d'un appareil de protection électrique, dans lequel le procédé comporte :
- la mesure de l'intensité d'un courant électrique alternatif circulant dans au moins un conducteur électrique (8) d'une installation électrique (2) comportant un appareil de protection électrique (4), au moyen d'un capteur de courant (20) d'un appareil auxiliaire (6) associé au conducteur électrique ;
- le calcul, par une unité électronique de traitement de l'appareil auxiliaire (6), de valeurs représentatives du courant électrique mesuré, lesdites valeurs représentatives étant chacune calculées à partir des valeurs d'intensité mesurées pendant un intervalle de temps prédéfini, les valeurs représentatives du courant électrique incluant l'intensité maximale du courant mesuré (I_{PEAK}) et la valeur efficace du courant mesuré (I_{RMS}) ;
- l'enregistrement des valeurs calculées dans une mémoire (36, 38) de l'appareil auxiliaire ;
la mesure, le calcul et l'enregistrement étant réalisés de façon répétée tant qu'un courant électrique circule dans ledit conducteur électrique ;
**caractérisé en ce que** le procédé comporte, postérieurement à une détection (S100) par l'appareil auxiliaire (6) d'une perte d'alimentation électrique dans ledit conducteur électrique (8), la détermination (S112, S124) d'un type de défaut électrique à partir des valeurs enregistrées, la détermination comportant :
- la comparaison (S108), avec une première valeur de seuil, de la plus grande valeur de l'intensité maximale du courant (I_{PEAK}) parmi les valeurs enregistrées pour plusieurs intervalles de mesure précédant la perte de l'alimentation électrique, un court-circuit étant diagnostiqué (S112) si la plus grande valeur de l'intensité maximale est supérieure à la première valeur de seuil ;
la comparaison (S122), avec une deuxième valeur de seuil, de la plus grande valeur de valeur efficace du courant (I_{RMS}) parmi les valeurs enregistrées pour plusieurs intervalles de mesure précédant la perte de l'alimentation électrique, une surcharge étant diagnostiquée (S124) si la plus grande valeur de valeur efficace est supérieure à la deuxième valeur de seuil, dans lequel la première valeur de seuil est calculée automatiquement, postérieurement à la détection de perte d'alimentation électrique, en fonction des valeurs d'intensité maximale (I_{PEAK}) du courant mesuré préalablement enregistrées pour plusieurs intervalles de temps précédant la détection de perte d'alimentation électrique, et dans lequel le calcul de la première valeur de seuil comporte :
- la détermination de la plus grande valeur (I_{PEAK-MAX}) de l'intensité maximale du courant (I_{PEAK}) de l'intensité maximale du courant (I_{PEAK}) parmi les valeurs enregistrées pour plusieurs intervalles de temps précédant la perte de l'alimentation électrique ;
- la détermination de la plus petite valeur (I_{PEAK-MIN}) de l'intensité maximale du courant (I_{PEAK}) parmi les valeurs enregistrées pour plusieurs intervalles de temps précédant la perte de l'alimentation électrique ;
- le calcul de la valeur moyenne entre la plus petite valeur (I_{PEAK-MIN}) et la plus grande valeur (I_{PEAK-MAX}) déterminées de l'intensité maximale du courant (I_{PEAK}), la première valeur de seuil étant définie égale à la valeur moyenne calculée.

2. Procédé selon la revendication 1, **caractérisé en ce que**, lors du calcul de la première valeur de seuil, les valeurs enregistrées de l'intensité maximale du courant (I_{PEAK}) qui sont associées à des intervalles de temps (74) postérieurs à l'intervalle de temps (72) correspondant à la plus grande valeur (I_{PEAK-MAX}) déterminée de l'intensité maximale du courant (I_{PEAK}) sont ignorées pour la détermination de la plus petite valeur (I_{PEAK-MIN}), la plus petite valeur (I_{PEAK-MIN}) de l'intensité maximale du courant (I_{PEAK}) étant déterminée parmi les seules valeurs enregistrées correspondant aux intervalles de temps (76) antérieurs à l'intervalle de temps (72) correspondant à la plus grande valeur (I_{PEAK-MAX}) déterminée.

3. Procédé selon la revendication 1 ou la revendication 2, **caractérisé en ce que**, lors de la détermination d'un type de défaut électrique, aucun court-circuit n'est diagnostiqué si la plus grande valeur (I_{PEAK-MAX}) déterminée de l'intensité maximale du courant (I_{PEAK}) est inférieure à deux fois la plus petite valeur (I_{PEAK-MIN}) déterminée de l'intensité maximale du courant (I_{PEAK}).

4. Procédé selon l'une quelconque des revendications précédentes, **caractérisé en ce que**, lors de la détermination d'un type de défaut électrique, un court-circuit n'est diagnostiqué que si, en plus, la plus grande valeur (I_{PEAK-MAX}) de l'intensité maximale du courant (I_{PEAK}) parmi les valeurs enregistrées pour plusieurs intervalles de temps précédant la perte de l'alimentation électrique est supérieure ou égale à deux fois la valeur de courant de calibre (Iₙ) de l'appareil de protection (4).

5. Procédé selon l'une quelconque des revendications précédentes, **caractérisé en ce que** la deuxième valeur de seuil est supérieure à la valeur de courant de calibre (Iₙ) et inférieure à deux fois ladite valeur de courant de calibre (Iₙ) de l'appareil de protection (4).

6. Procédé selon l'une quelconque des revendications précédentes, **caractérisé en ce que**, lorsque la détermination (S112, S124) d'un type de défaut électrique a conduit à la détection à la fois d'un court-circuit et d'une surcharge (S132), seule la détection du court-circuit est prise en compte, la détection de la surcharge étant alors dans ce cas automatiquement ignorée (S136).

7. Procédé selon l'une quelconque des revendications précédentes, **caractérisé en ce qu'**il comporte, lors de la détection d'un défaut électrique de type courant de surcharge, l'enregistrement (S128), dans une mémoire (40) de l'appareil auxiliaire (6), de la plus grande valeur de valeur efficace du courant (I_{RMS}).

8. Procédé selon l'une quelconque des revendications précédentes, **caractérisé en ce qu'**il comporte, postérieurement à la détermination du type de défaut électrique, l'envoi (S134) d'un message de diagnostic représentatif du type de défaut électrique déterminé, à destination d'un concentrateur (14), au moyen d'une interface de communication sans fil (44) de l'appareil auxiliaire (6) et/ou l'enregistrement (S134), dans une mémoire (40) de l'appareil auxiliaire (6), d'une information de diagnostic représentative du type de défaut électrique déterminé.

9. Procédé selon l'une quelconque des revendications précédentes, **caractérisé en ce que** la durée des intervalles de temps est proportionnelle à la période du courant électrique alternatif circulant dans ledit conducteur électrique (8).

10. Appareil auxiliaire (6) pour une installation électrique (2) comprenant un appareil de protection électrique (4) associé à au moins un conducteur électrique (8), l'appareil auxiliaire (6) comportant un capteur de courant (20) associé au conducteur électrique (8), une unité électronique de traitement (28) et au moins une mémoire (36, 38, 40), **caractérisé en ce que** l'appareil auxiliaire (6) est configuré pour mettre en oeuvre un procédé de diagnostic de la cause de déclenchement de l'appareil de protection électrique (4) conforme à l'une quelconque des revendications précédentes.

11. Système électrique comportant un appareil de protection électrique (4) et un appareil auxiliaire (6) associés à au moins un conducteur électrique (8) d'une installation électrique (2), l'appareil de protection électrique (4) étant adapté pour interrompre la circulation d'un courant électrique dans le conducteur électrique (8) en cas de détection d'un défaut électrique, **caractérisé en ce que** l'appareil auxiliaire (6) est selon la revendication 10.

## Patentansprüche

1. Verfahren zur Diagnose der Auslösungsursache eines elektrischen Schutzgeräts, wobei das Verfahren Folgendes umfasst:
- Messen der Stärke eines elektrischen Wechselstroms, der in mindestens einem elektrischen Leiter (8) einer elektrischen Anlage (2) umfassend ein elektrisches Schutzgerät (4) fließt, mittels eines Stromsensors (20) eines Hilfsgeräts (6), das mit dem elektrischen Leiter assoziiert ist;
- Berechnen, durch eine elektronische Verarbeitungseinheit des Hilfsgeräts (6), von repräsentativen Werten des gemessenen elektrischen Stroms, wobei die repräsentativen Werte jeweils aus den gemessenen Stromwerten während eines vordefinierten Zeitintervalls berechnet werden, wobei die repräsentativen Werte des elektrischen Stroms die maximale gemessene Stromstärke (I_{PEAK}) und den Effektivwert des gemessenen Stroms (I_{RMS}) beinhalten;
- Aufzeichnen der berechneten Werte in einem Speicher (36, 38) des Hilfsgeräts;
wobei das Messen, Berechnen und Aufzeichnen wiederholt, durchgeführt wird, solange ein elektrischer Strom in dem elektrischen Leiter fließt;
**dadurch gekennzeichnet, dass** das Verfahren nach einer Erfassung (S100) durch das Hilfsgerät (6) eines Ausfalls der elektrischen Versorgung in dem elektrischen Leiter (8) die Bestimmung (S112, S124) eines Typs eines elektrischen Fehlers aus den aufgezeichneten Werten umfasst, die Bestimmung umfassend:
- Vergleichen (S108) des größten Werts der maximalen Stromstärke (I_{PEAK}) von den Werten, die für mehrere Messintervalle vor dem Ausfall der Stromversorgung aufgezeichnet werden, mit einem ersten Schwellenwert, wobei ein Kurzschluss diagnostiziert wird (S112), wenn der größte Wert der maximalen Stromstärke größer ist als der erste Schwellenwert;
Vergleichen (S122) des größten Effektivwerts des Stroms (I_{RMS}) von den Werten, die für mehrere Messintervalle vor dem Ausfall der Stromversorgung aufgezeichnet werden, mit einem zweiten Schwellenwert, wobei eine Überlastung diagnostiziert wird (S124), wenn der größte Effektivwert größer ist als der zweite Schwellenwert, wobei der erste Schwellenwert automatisch nach der Erfassung des Ausfalls der Stromversorgung abhängig von den maximalen Stromstärkewerten (I_{PEAK}) des gemessenen Stroms berechnet wird, die zuvor für mehrere Zeitintervalle vor der Erfassung des Ausfalls der Stromversorgung aufgezeichnet werden, und wobei die Berechnung des ersten Schwellenwerts Folgendes umfasst:
- Bestimmen des größten Werts (I_{PEAK-MAX}) der maximalen Stromstärke (I_{PEAK}) der maximalen Stromstärke (I_{PEAK}) von den Werten, die für mehrere Zeitintervalle vor dem Ausfall der Stromversorgung aufgezeichnet werden;
- Bestimmen des kleinsten Werts (I_{PEAK-MIN}) der maximalen Stromstärke (I_{PEAK}) von den Werten, die für mehrere Zeitintervalle vor dem Ausfall der Stromversorgung aufgezeichnet werden;
- Berechnen des Mittelwerts zwischen dem kleinsten Wert (I_{PEAK-MIN}) und dem größten Wert (I_{PEAK-MAX}) ermittelten maximalen Stromstärke (I_{PEAK}), wobei der erste Schwellenwert als gleich wie der berechnete Mittelwert definiert wird.

2. Verfahren nach Anspruch 1, **dadurch gekennzeichnet, dass** beim Berechnen des ersten Schwellenwerts die aufgezeichneten Werte der maximalen Stromstärke (I_{PEAK}), die mit Zeitintervallen (74) nach dem Zeitintervall (72) assoziiert sind, das dem bestimmten größten Wert (I_{PEAK-MAX}) der maximalen Stromstärke (I_{PEAK}) entspricht, beim Bestimmen des kleinsten Werts (I_{PEAK-MIN}) ignoriert werden, wobei der kleinste Wert (I_{PEAK-MIN}) der maximalen Stromstärke (I_{PEAK}) von den einzigen aufgezeichneten Werten bestimmt wird, die den Zeitintervallen (76) vor dem Zeitintervall (72) entsprechen, das dem bestimmten größten Wert (I_{PEAK-MAX}) entspricht.

3. Verfahren nach Anspruch 1 oder 2, **dadurch gekennzeichnet, dass** beim Bestimmen eines Typs elektrischen Fehlers kein Kurzschluss diagnostiziert wird, wenn der größte bestimmte Wert (I_{PEAK-MAX}) der maximalen Stromstärke (I_{PEAK}) kleiner ist als das Zweifache des kleinsten bestimmten Werts (I_{PEAK-MIN}) der maximalen Stromstärke (I_{PEAK}) ist.

4. Verfahren nach einem der vorherigen Ansprüche, **dadurch gekennzeichnet, dass** beim Bestimmen eines elektrischen Fehlertyps ein Kurzschluss nur dann diagnostiziert wird, wenn zusätzlich der größte Wert (I_{PEAK-MAX}) der maximalen Stromstärke (I_{PEAK}) von den Werten, die für mehrere Zeitintervalle vor dem Ausfall der Stromversorgung aufgezeichnet werden, größer als oder gleich wie das Zweifache des Kalibrierstromwerts (Iₙ) des Schutzgeräts (4) ist.

5. Verfahren nach einem der vorherigen Ansprüche, **dadurch gekennzeichnet, dass** der zweite Schwellenwert größer als der Kaliberstromwert und kleiner als das Zweifache des Kaliberstromwerts des Schutzgeräts (4) ist.

6. Verfahren nach einem der vorherigen Ansprüche, **dadurch gekennzeichnet, dass**, wenn das Bestimmen (S112, S124) eines Typs eines elektrischen Fehlers zur Erfassung sowohl eines Kurzschlusses als auch einer Überlast (S132) geführt hat, nur die Erfassung des Kurzschlusses berücksichtigt wird, wobei dann die Erfassung der Überlast in diesem Fall automatisch ignoriert wird (S136).

7. Verfahren nach einem der vorherigen Ansprüche, **dadurch gekennzeichnet, dass** es bei der Erfassung eines elektrischen Fehlers vom Typ Überlaststrom das Aufzeichnen (S128) des größten Werts des Effektivwerts des Stroms (I_{RMS}) in einem Speicher (40) des Hilfsgeräts (6) umfasst.

8. Verfahren nach einem der vorherigen Ansprüche, **dadurch gekennzeichnet, dass** es nach Bestimmen des Typs eines elektrischen Fehlers ein Senden (S134) einer für den bestimmten Typ des elektrischen Fehlers repräsentativen Diagnosemeldung an einen Konzentrator (14) mittels einer drahtlosen Kommunikationsschnittstelle (44) des Hilfsgeräts (6) und/oder ein Aufzeichnen (S134) von für den bestimmten Typ eines elektrischen Fehlers repräsentativen Diagnoseinformationen in einem Speicher (40) des Hilfsgeräts (6) umfasst.

9. Verfahren nach einem der vorherigen Ansprüche, **dadurch gekennzeichnet, dass** die Dauer der Zeitintervalle proportional zu der Periode des elektrischen Wechselstroms ist, der in dem elektrischen Leiter (8) fließt.

10. Hilfsgerät (6) für eine elektrische Anlage (2), umfassend ein elektrisches Schutzgerät (4), das mit mindestens einem elektrischen Leiter (8) assoziiert ist, das Hilfsgerät (6) umfassend einen mit dem elektrischen Leiter (8) assoziierten Stromsensor (20), eine elektronische Verarbeitungseinheit (28) und mindestens einen Speicher (36, 38, 40), **dadurch gekennzeichnet, dass** das Hilfsgerät (6) konfiguriert ist, um ein Verfahren zur Diagnose der Auslösungsursache des elektrischen Schutzgeräts (4) gemäß einem der vorherigen Ansprüche implementiert.

11. Elektrisches System, umfassend ein elektrisches Schutzgerät (4) und ein Hilfsgerät (6), die mit mindestens einem elektrischen Leiter (8) einer elektrischen Installation (2) assoziiert sind, wobei das elektrische Schutzgerät (4) angepasst ist, um den Fluss eines elektrischen Stroms in dem elektrischen Leiter (8) zu unterbrechen, wenn ein elektrischer Fehler erkannt wird, **dadurch gekennzeichnet, dass** das Hilfsgerät (6) gemäß Anspruch 10 ist.

## Claims

1. A method of diagnosing the cause of tripping of an electrical protection device, wherein the method comprises:
- measuring the intensity of an alternating electrical current flowing in at least one electrical conductor (8) of an electrical installation (2) having an electrical protection device (4), by means of a current sensor (20) of an auxiliary device (6) associated with the electrical conductor;
- calculating, by an electronic processing unit of the auxiliary device (6), representative values of the measured electrical current, said representative values each being calculated from the current values measured during a predefined time interval, the representative values of the electrical current including the peak intensity of the measured current (I_{PEAK}) and the root mean square value of the measured current (I_{RMS});
- storing the calculated values in a memory (36, 38) of the auxiliary device;
the measuring, calculating, and storing being carried out repeatedly as long as an electrical current is flowing in said electrical conductor;
**characterised in that** the method comprises, subsequent to a detection (S100) by the auxiliary device (6) of a loss of electrical power in said electrical conductor (8), determining (S112, S124) a type of electrical fault from the stored values, the determination comprising:
- comparing (S108) the largest value of the peak intensity of the current (I_{PEAK}) among the values stored for a plurality of measurement intervals prior to the loss of the power supply to a first threshold value, wherein a short-circuit is diagnosed (S112) if the largest value of the peak intensity of the current is greater than the first threshold value;
comparing (S122) the largest root mean square value of the current (I_{RMS}) among the values stored for a plurality of measurement intervals prior to the loss of the power supply to a second threshold value, an overload being diagnosed (S124) if the largest root mean square value is greater than the second threshold value, wherein the first threshold value is automatically calculated, subsequent to the detection of loss of power supply, based on the values of the peak intensity (I_{PEAK}) of the measured current previously stored for a plurality of time intervals prior to the detection of the loss of power supply, and wherein the calculation of the first threshold value comprises:
- determining the largest value (I_{PEAK-MAX}) of the peak intensity of the current (I_{PEAK}) from among the values stored for a plurality of time intervals prior to the loss of the power supply;
- determining the smallest value (I_{PEAK-MIN}) of the peak intensity of the current (I_{PEAK}) from among the values stored for a plurality of time intervals prior to the loss of the power supply;
- calculating the average value between the determined smallest value (I_{PEAK-MIN}) and largest value (I_{PEAK-MAX}) of the peak intensity of the current (I_{PEAK}), where the first threshold value is set to be equal to the calculated average value.

2. The method according to claim 1, **characterised in that**, when calculating the first threshold value, the stored values of the peak intensity of the current (I_{PEAK}) which are associated with time intervals (74) after the time interval (72) corresponding to the determined largest value (I_{PEAK-MAX}) of the peak intensity of the current (I_{PEAK}) are ignored for the determination of the smallest value (I_{PEAK-MIN}), the smallest value (I_{PEAK-MIN}) of the peak intensity of the current (I_{PEAK}) being determined only from the stored values corresponding to the time intervals (76) prior to the time interval (72) corresponding to the determined largest value (I_{PEAK-MAX}).

3. The method according to claim 1 or claim 2, **characterised in that**, when determining a type of electrical fault, no short circuit is diagnosed if the determined largest value (I_{PEAK-MAX}) of the peak intensity of the current (I_{PEAK}) is less than twice the determined smallest value (I_{PEAK-MIN}) of the peak intensity of the current (I_{PEAK}).

4. The method according to any one of the preceding claims, **characterised in that**, when determining a type of electrical fault, a short circuit is diagnosed only if, in addition, the largest value (I_{PEAK-MAX}) of the peak intensity of the current (I_{PEAK}) of the values stored for a plurality of time intervals preceding the loss of the power supply is greater than or equal to twice the rating current value of the protection device (4).

5. The method according to any of the preceding claims, **characterised in that** the second threshold value is greater than the rating current value and less than twice said rating current value of the protection device (4).

6. The method according to any of the preceding claims, **characterised in that**, when the determination (S112, S124) of a type of electrical fault has led to the detection of both a short-circuit and an overload (S132), only the detection of the short-circuit is taken into account, the detection of the overload then being automatically ignored (S136).

7. The method according to any one of the preceding claims, **characterised in that** it comprises, on detection of an electrical fault of the overload current type, storing (S128), in a memory (40) of the auxiliary device (6), the greatest value of the root mean square value of the current (I_{RMS}).

8. The method according to any one of the preceding claims, **characterised in that** it comprises, after the type of electrical fault has been determined, sending (S134) a diagnostic message representative of the type of electrical fault determined, to a concentrator (14), by means of a wireless communication interface (44) of the auxiliary device (6) and/or storing (S134), in a memory (40) of the auxiliary device (6), diagnostic information representative of the type of electrical fault determined.

9. The method according to any one of the preceding claims, **characterised in that** the duration of the time intervals is proportional to the period of the alternating electrical current flowing in said electrical conductor (8).

10. An auxiliary device (6) for an electrical installation (2) comprising an electrical protection device (4) associated with at least one electrical conductor (8), the auxiliary device (6) comprising a current sensor (20) associated with the electrical conductor (8), an electronic processing unit (28) and at least one memory (36, 38, 40), **characterised in that** the auxiliary device (6) is configured to implement a method of diagnosing the cause of the tripping of the electrical protection device (4) in accordance with any of the preceding claims.

11. An electrical system comprising an electrical protection device (4) and an auxiliary device (6) associated with at least one electrical conductor (8) of an electrical installation (2), the electrical protection device (4) being adapted to interrupt the flow of an electrical current in the electrical conductor (8) in the event of an electrical fault being detected, **characterised in that** the auxiliary device (6) is according to claim 10.
